# EUROPÄISCHE PATENTSCHRIFT

(11) **EP 2 215 407 B1**
(45) Veröffentlichungstag und Bekanntmachung des Hinweises auf die Patenterteilung: **20.09.2017**
(21) Anmeldenummer: 08851997.0
(22) Anmeldetag: 27.10.2008
(51) Int. Cl.: F24C 7/08, H03K 17/97

(54) **BEDIENVORRICHTUNG FÜR EIN HAUSGERÄT**
OPERATING DEVICE FOR A HOUSEHOLD APPLIANCE
DISPOSITIF DE COMMANDE POUR UN APPAREIL MÉNAGER

(30) Priorität: 23.11.2007 DE 102007056416
(43) Veröffentlichungstag der Anmeldung: 11.08.2010
(73) Patentinhaber: BSH Hausgeräte GmbH, 81739 München (DE)
(72) Erfinder: SCHMAL, Stefan, 84101 Niedersüssbach (DE); VORMANN, Ingo, 83413 Fridolfing (DE); WURNITSCH, Ernst, A-6382 Kirchdorf in Tirol (AT)
(74) Vertreter: Richter, Harald
(86) Internationale Anmeldenummer: PCT/EP2008/064521
(87) Internationale Veröffentlichungsnummer: WO 2009/065704

(56) Entgegenhaltungen:
- EP-A2- 1 347 242
- DE-A1- 10 218 294
- DE-U1-202005 019 978

## Beschreibung

Die Erfindung betrifft eine Bedienvorrichtung für ein Hausgerät, mit einem Bedienelement, welches auf einer Bedienfläche des mit der Bedienvorrichtung steuerbaren Hausgeräts mittels Magnetkraft haltbar ist und relativ zur Bedienfläche bewegbar und von dort' abnehmbar positioniert werden kann.

Eine derartige Bedienvorrichtung ist aus der DE 10 2005 018 275 A1 bekannt. Dort ist das Bedienelement als massives Teil ausgebildet, welches lediglich einen Magneten umfasst, der mittig zentriert an einer Unterseite des Bedienelements angeordnet ist.

Darüber hinaus ist aus der DE 10 2004 020 825 A1 ein Bedienelement bekannt, welches auf einer Bedienfläche eines Hausgeräts mittels Magnetkraft drehbar und abnehmbar gehaltert ist. Das Bedienelement umfasst mehrere, einen inneren Hohlraum begrenzende Teile, beispielsweise ein Griffteil und eine Laufplatte, in welchem Hohlraumfunktionselemente wie ein Magnet und dergleichen angeordnet sind. Darüber hinaus sind in dem Hohlraum sternförmige Arme aus ferromagnetischem Material positioniert. Aufgrund der Ausgestaltung des Bedienelements ist dies relativ hoch bauend ausgebildet und daher relativ sperrig und groß.

Aus der DE 102 18 294 A1 ist ein lediglich zum Drehen auf einer Kochfläche ausgebildetes Bedienelement bekannt. Der Drehknebel kann aus einem ferromagnetischen Edelstahl ausgebildet sein. In Wechselwirkung mit unter der Kochfläche angebrachten magnetischen Halteelementen kann dadurch lediglich das Halten und Drehen auf der Kochfläche durch Magnetkraft gewährleistet werden.

Es ist Aufgabe der vorliegenden Erfindung, eine Bedienvorrichtung zu schaffen, bei welcher das Bedienelement kompakt und möglichst flach bauend ausgestaltet ist.

Diese Aufgabe wird durch eine Bedienvorrichtung, welche die Merkmale nach Anspruch 1 aufweist, gelöst.

Eine erfindungsgemäße Bedienvorrichtung für ein Hausgerät umfasst eine Bedienfläche und ein Bedienelement, welches auf der Bedienfläche des mit der Bedienvorrichtung steuerbaren Hausgeräts mittels Magnetkraft haltbar ist und relativ zur Bedienfläche bewegbar und von dort abnehmbar positionierbar ist. Eine obere Abdeckung des Bedienelements ist zumindest bereichsweise aus einem ferromagnetischen Material ausgebildet. Durch diese Ausgestaltung des Deckels bzw. der Abdeckung des Bedienelements kann diese multifunktional ausgestaltet werden, da es zum einen den oberen Abschluss des Bedienelements bildet und andererseits durch die Ausgestaltung aus einem ferromagnetischen Material zur prinzipiellen Funktion im Hinblick auf die Steuerung der Bedienvorrichtung über Magnetfeldänderungen und deren Detektion ausgebildet ist. Durch diese Multifunktionalität der Abdeckung kann zumindest ein Bauteil eingespart werden, da die ansonsten übliche Deckelung aus einem anderen Material nicht mehr zusätzlich erforderlich ist. Dadurch kann das Bedienelement sehr flach bauend ausgestaltet werden und dadurch kompakt und handlich gestaltet werden.

Dies ist insbesondere für die Griffigkeit und Bedienbarkeit vorteilhaft. Darüber hinaus kann durch diese Ausgestaltung auch eine Gewichtsreduzierung des Bedienelements erreicht werden, wodurch auch die präzisere Bewegung des Bedienelements und die einfachere Handhabbarkeit gewährleistet werden kann.

Die Abdeckung ist funktionell einem Auswertesystem der Bedienvorrichtung zugeordnet. Eine durch die Bewegung des Bedienelements auf der Bedienfläche hervorgerufene Änderung von Magnetfeldern wird in Kombination zwischen der Bewegung der Abdeckung und auf und/oder unter der Bedienfläche angeordneten weiteren Magneten bewirkt, so dass über diese Detektion die Bewegung des Bedienelements erkannt und dadurch die erwünschte Steuerung des Hausgeräts oder von Komponenten davon bewirkt werden kann. Dies ist dann funktionell mit dem Auswertesystem im Hinblick auf die Bewegungsdetektion und -erkennung und der damit verbundenen gewünschten Steuerung einhergehen.

Die Abdeckung bzw. Kappe oder der nach oben hin das Bedienelement abschließende Deckel ist vorzugsweise einstückig ausgebildet. Dadurch kann ein mechanisch stabiles Teil bereit gestellt werden, welches relativ einfach in einem Fertigungsvorgang gefertigt werden kann. Insbesondere ist die Abdeckung als ein Drehteil ausgebildet und wird somit durch einen mechanischen Bearbeitungsvorgang des Drehens aus einem entsprechenden Grundteil geformt bzw. gefertigt.

Vorzugsweise ist die Abdeckung zumindest bereichsweise aus einem ferromagnetischen Edelstahl ausgebildet. Dies hat neben der grundsätzlichen Funktionalität zur Beitragung der Signalerzeugung und -auswertung im Hinblick auf die Steuerung des Hausgeräts auch einen hohen Designanspruch. Es kann somit auch ein hochwertiger Eindruck vermittelt werden.

Besonders bevorzugt erweist es sich, wenn die Abdeckung zumindest bereichsweise aus dem Material mit der Werkstoffnummer 1.4021 ausgebildet ist. Dies ist ein besonders geeigneter ferromagnetischer Edelstahl, welcher eine besonders zuverlässige Erzeugung und Erkennung von Magnetfeldänderungen ermöglicht und dadurch eine sehr präzise Positionsänderung des Bedienelements und der damit verbundenen und gewünschten Steuerung des Hausgeräts ermöglicht.

Es kann auch vorgesehen sein, dass die Abdeckung zusätzlich oder anstatt dem Werkstoff 1.4021 zumindest bereichsweise aus dem Material mit der Werkstoffnummer 1.4104 und/oder 1.4105 gefertigt ist, welche jeweils ebenfalls ferromagnetische Edelstähle darstellen. Ebenso kann vorgesehen sein, dass die obere Abdeckung zumindest bereichsweise zusätzlich oder anstatt zumindest einem der oben genannten Materialien aus einem Material mit der Werkstoffnummer 1.4006 und/oder 1.4028 und/oder 1.4031 und/oder 1.4016 ausgebildet ist.

Vorzugsweise weist die Abdeckung einen am Rand umlaufenden Steg auf, welcher aus ferromagnetischem Material ausgebildet ist. Insbesondere ist die Abdeckung vollständig aus einem ferromagnetischen Material, insbesondere einem ferromagnetischen Edelstahl, ausgebildet. Durch diese topfartige Ausgestaltung der Abdeckung kann diese auch randseitig als Abschluss des Bedienelements ausgebildet sein, so dass sie auch vorzugsweise zur Aufnahme anderer, insbesondere aller Komponenten, des Bedienelements ausgebildet ist. Diese können somit kompakt und bauraumminimiert quasi in der Abdeckung positioniert und gehalten werden.

Vorzugsweise weist das Bedienelement einen Zentralmagnet auf, welcher axial zur Rotationsachse bzw. Längsachse des Bedienelements angeordnet ist. Dieser Zentralmagnet ist vorzugsweise an der Innenseite der Abdeckung angeordnet. Darüber hinaus sind eine Mehrzahl, vorzugsweise sechs, weitere Außenmagnete im Inneren der Abdeckung angeordnet, welche in radialer Richtung zwischen dem Zentralmagnet und dem Rand der Abdeckung angeordnet sind. Vorzugsweise sind diese Außenmagnete als zylinderförmige Stifte konzipiert, welche an der Innenseite der Abdeckung angeordnet sind.

Vorzugsweise weist das Bedienelement darüber hinaus eine untere Abdeckung auf, welche zerstörungsfrei lösbar mit der oberen Abdeckung verbunden ist. Darüber hinaus ist die Verbindungsstelle vorzugsweise abgedichtet, wobei diesbezüglich beispielsweise ein O-Ring vorgesehen sein kann. Die lösbare Verbindung zwischen der oberen und der unteren Abdeckung des Bedienelements kann beispielsweise durch einen Rastmechanismus vorgesehen sein. Insbesondere ist diese untere Abdeckung an ihrer Außenseite mittig mit einem ebenen oder zumindest nur sehr leicht gewölbten Bereich ausgebildet, welcher bei einer leichten Wölbung kegelförmig ausgebildet sein kann. Anschließend an diesen zentralen Bereich ist ein zur oberen Abdeckung hin geneigter Teilbereich ausgebildet, so dass im zusammengesetzten Zustand des Bedienelements dieses in einer Grundposition stabil auf die Bedienfläche positioniert werden kann und aufgrund der Schrägneigung der weiteren Teilbereiche auch gekippt werden kann.

Die obere Abdeckung ist vorzugsweise ebenfalls einstückig ausgebildet und kann beispielsweise aus Kunststoff sein. Die untere Abdeckung umfasst vorzugsweise Aufnahmebereiche, in welchen einerseits der Zentralmagnet und andererseits die Außenmagnete eingesetzt werden können. Dadurch können diese haltend umgriffen werden und darüber hinaus die mechanisch stabile Zusammensetzung des Bedienelements gewährleistet werden.

Ein Ausführungsbeispiel der Erfindung wird nachfolgend anhand schematischer Zeichnungen näher erläutert. Es zeigen:
- Fig. 1: eine perspektivische Darstellung eines Hausgeräts mit einer erfindungsgemäßen Bedienvorrichtung;
- Fig. 2: eine perspektivische Darstellung eines Bedienelements der Bedienvorrichtung im Teilschnitt;
- Fig. 3: eine Draufsicht auf das Bedienelement gemäß Fig. 2; und
- Fig. 4: eine Schnittdarstellung des Bedienelements gemäß Fig. 2 und Fig. 3.

In den Figuren werden gleiche oder funktionsgleiche Elemente mit den gleichen Bezugszeichen versehen.

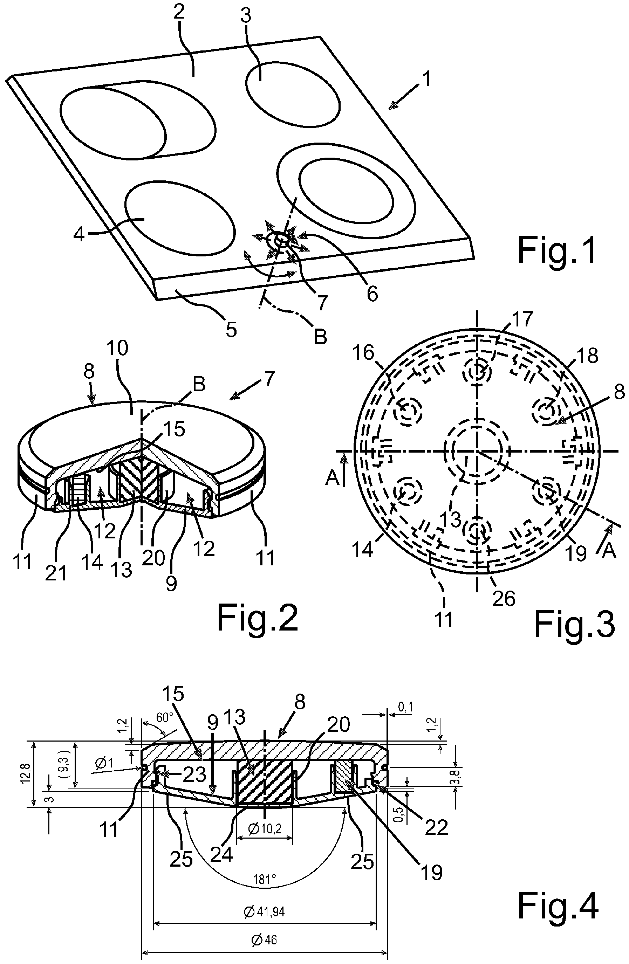

In Fig. 1 ist in einer schematischen Darstellung ein als Kochfeld 1 ausgebildetes Hausgerät gezeigt. Das Kochfeld 1 umfasst eine Kochfläche 2, welche aus Glaskeramik ausgebildet sein kann. Auf der Kochfläche 2 sind eine Mehrzahl von Kochzonen ausgebildet, von denen lediglich die Kochzonen 3 und 4 näher gekennzeichnet sind. Auf diesen Kochzonen 3 und 4 können Zubereitungsgefäße für Lebensmittel aufgestellt werden, wobei die Kochzonen 3 und 4 heizbar sind. Benachbart zur Vorderseite 5 des Kochfelds 1 ist eine Bedienvorrichtung 6 angeordnet. Die Bedienvorrichtung 6 umfasst ein Bedienelement 7, welches auf der Kochfläche 2 an der gezeigten Position aufsetzbar und abnehmbar ist. Dabei wird das Bedienelement 7 über eine Haltekraft, insbesondere eine magnetische Kraft, gehalten. Das Bedienelement 7 kann sowohl um die Achse B gedreht, als auch gekippt werden. Die Bedienvorrichtung 6 ist zur Steuerung des Kochfelds 1 ausgebildet. Diesbezüglich können Betriebszustände verändert oder Einstellungen von Parametern verändert werden. Dies kann durch die Drehbewegung und/oder die Kippbewegung des Bedienelements 7 auf der Kochfläche 2 erfolgen. Durch die Drehbewegung und/oder Kippbewegung werden örtlich Magnetfelder in ihrer Stärke verändert, was durch ein Auswertesystem, welches der Bedienvorrichtung 6 zugeordnet ist, erfasst wird, und abhängig davon kann die gewünschte Steuerung oder Einstellung erfolgen.

Dazu können an der Unterseite der Kochfläche 2 Gegenmagnete angeordnet sein, welche in Wechselwirkung mit dem Bedienelement, welches bereichsweise magnetisch ausgebildet ist, die Magnetfeldänderungen erzeugen.

In Fig. 2 ist in einer perspektivischen Darstellung das Bedienelement 7 gezeigt, wobei in dem Zusammenhang ein Teilschnitt gezeigt ist. Das Bedienelement 7 ist im Ausführungsbeispiel sehr flach bauend ausgebildet und weist eine scheibenförmige bzw. diskusförmige Struktur auf.

Das Bedienelement 7 umfasst eine obere Abdeckung 8 und eine untere Abdeckung 9. Die obere Abdeckung 8 ist einstückig ausgebildet und im Ausführungsbeispiel vollständig aus einem ferromagnetischen Edelstahl, insbesondere aus dem Material 1.4021, ausgebildet.

Die obere Abdeckung 8 ist so dimensioniert, dass sie quasi nach oben hin den abschließenden Deckel des Bedienelements 7 bildet und im Hinblick auf ihre radialen Ausmaße die Dimensionierung des Bedienelements 7 vorgibt. Dazu weist die obere Abdeckung 8 ein plattenartiges Teil 10 auf, an dem randseitig umlaufend ein Steg 11 angeformt ist. Dadurch wird unter der oberen Abdeckung 8 ein Aufnahmeraum 12 gebildet, welcher zur Aufnahme weiterer Funktionskomponenten des Bedienelements 7 dient. In diesem Zusammenhang ist in diesem Aufnahmeraum 12 ein Zentralmagnet 13 positioniert, welcher axial zur Achse B angeordnet ist. Des Weiteren sind eine Mehrzahl, insbesondere sechs, Außenmagnete in dem Aufnahmeraum 12 positioniert. In Fig. 2 ist lediglich der Außenmagnet 14 im Schnitt zu erkennen. Die Außenmagnete sind zylinderförmige Stifte, welche an der Innenseite 15 des plattenartigen Teils 10 der oberen Abdeckung 8 angeordnet sind. In entsprechender Weise ist der Zentralmagnet 13 an dieser Innenseite 15 angebracht. Die Außenmagnete 14 und 16, 17, 18, 19 und 26 (Fig. 3) sind in radialer Richtung zwischen dem Zentralmagnet 13 und dem Steg 11 der oberen Abdeckung 8 jeweils beabstandet dazu positioniert.

Darüber hinaus sind die im Ausführungsbeispiel sechs Außenmagnete 14 und 16 bis 19 in Umlaufrichtung äquidistant zueinander angeordnet.

Die untere Abdeckung 9 ist vorzugsweise aus Kunststoff ausgebildet und reversibel lösbar mit der oberen Abdeckung 8 verbunden. Darüber hinaus ist eine Abdichtung vorgesehen, so dass in den Aufnahmeraum 12 keine Flüssigkeit oder dergleichen eindringen kann. Zur Verbindung der oberen Abdeckung 8 mit der unteren Abdeckung 9 ist ein Rastmechanismus vorgesehen.

Darüber hinaus sind an der unteren Abdeckung 9 einstückig angeformte Positionierbereiche bzw. Aufnahmebereiche für den Zentralmagneten 13 und die Außenmagnete 14 und 16 bis 19 vorgesehen. Der Zentralmagnet 13 ist dabei gemäß der Darstellung in Fig. 2 in einem topfartigen Positionierbereich 20 angeordnet bzw. eingesetzt. Der in Fig. 2 zu erkennende Außenmagnet 14 ist in einem Positionierbereich 21 angeordnet. Entsprechend sind die weiteren Außenmagnete 16 bis 19 in entsprechend ausgebildeten und hier nicht näher gekennzeichneten Positionierbereichen eingesetzt.

In Fig. 3 ist in einer durchsichtigen Draufsichtdarstellung das Bedienelement 7 gezeigt.

In Fig. 4 ist in einer Schnittdarstellung entlang einer Schnittlinie AA gemäß der Darstellung in Fig. 3 das Bedienelement 7 dargestellt. Es ist gezeigt, dass an der Verbindung zwischen der oberen Abdeckung 8 und der unteren Abdeckung 9 als Dichtung 22 ein O-Ring angeordnet ist. Darüber hinaus kann der Rastmechanismus 23 erkannt werden.

Die untere Abdeckung 9 weist mittig um die Achse B einen ebenen oder ganz leicht gewölbten Teil auf. Mit diesem kann das Bedienelement 7 in einer Grundposition auf der Kochfläche 2 angeordnet werden. In radialer Richtung anschließend an diesen mittigen Bereich 24 weist die untere Abdeckung 9 einen schräg nach oben orientierten, um den mittigen Bereich 24 vollständig umlaufenden Bereich 25 auf. Durch diese Anhebung bzw. Anschrägung nach oben kann die Geometrie bzw. Formgebung des Bedienelements 7 dahingehend geschaffen werden, dass es auch seitlich gekippt werden kann, so dass gegebenenfalls der Teilbereich 25 auf der Kochfläche 2 aufliegt oder diesem nahe kommt.

Abhängig von diesen Drehbewegungen und/oder Kippbewegungen des Bedienelements 7 auf der Kochfläche 2 können dann verschiedene Einstellungen und Steuerungen des Kochfelds 1 oder Komponenten davon erfolgen.

Darüber hinaus sind in Fig. 4 beispielhafte Maße in mm und beispielhafte Winkelwerte für Bereiche und Teile des Bedienelements 7 angegeben.

## Patentansprüche

1. Bedienvorrichtung für ein Hausgerät (1), mit einer Bedienfläche (2), mit einem Auswertesystem und mit einem Bedienelement (7), welches auf der Bedienfläche (2) des mit der Bedienvorrichtung (6) steuerbaren Hausgeräts (1) mittels Magnetkraft haltbar ist und relativ zur Bedienfläche (2) bewegbar und von dort abnehmbar positionierbar ist, wobei das Bedienelement eine obere Abdeckung (8) umfasst, welche zumindest bereichsweise aus ferromagnetischem Material ausgebildet ist,
wobei die Bedienfläche (2) weitere Magnete umfasst, die auf und/oder unter der Bedienfläche (2) angeordnet sind, **dadurch gekennzeichnet, dass**
die obere Abdeckung (8) funktionell dem Auswertesystem der Bedienvorrichtung (6) zugeordnet ist, derart, dass eine durch die Bewegung des Bedienelements (7) auf der Bedienfläche (2) hervorgerufene Änderung von Magnetfeldern, die durch eine Bewegung zwischen der Abdeckung (8) und den auf und/oder unter der Bedienfläche (2) angeordneten weiteren Magneten der Bedienvorrichtung bewirkt wird, erkannt und über diese Detektion der Änderung der Magnetfelder die Bewegung des Bedienelements (7) erkannt werden kann und dadurch die erwünschte Steuerung des Hausgeräts (1) oder von Komponenten davon bewirkt werden kann, wobei die obere Abdeckung (8) mit einer unteren Abdeckung (9) verbunden ist und dazwischen ein geschlossener Aufnahmeraum (12) für Funktionskomponenten des Bedienelements (7) ausgebildet ist.

2. Bedienvorrichtung nach Anspruch 1, **dadurch gekennzeichnet, dass** die obere Abdeckung (8) zumindest bereichsweise aus einem ferromagnetischen Edelstahl ausgebildet ist.

3. Bedienvorrichtung nach einem der vorhergehenden Ansprüche, **dadurch gekennzeichnet, dass** die obere Abdeckung (8) zumindest bereichsweise aus dem Material mit der Werkstoffnummer 1.4021 ausgebildet ist.

4. Bedienvorrichtung nach einem der vorhergehenden Ansprüche, **dadurch gekennzeichnet, dass** die obere Abdeckung (8) einen am Rand umlaufenden Steg (11) aufweist, welcher aus dem ferromagnetischen Material ausgebildet ist.

5. Bedienvorrichtung nach einem der vorhergehenden Ansprüche, **dadurch gekennzeichnet, dass** die obere Abdeckung (8) zur zumindest bereichsweisen Aufnahme anderer, insbesondere aller, Komponenten des Bedienelements (7) ausgebildet ist.

6. Bedienvorrichtung nach einem der vorhergehenden Ansprüche, **dadurch gekennzeichnet, dass** die obere Abdeckung (8) einstückig ausgebildet ist.

## Claims

1. Operating device for a household appliance (1), having an operating surface (2), with an evaluation system and with an operator control element (7) which can be held by means of magnetic force on the operating surface (2) of the household appliance (1), the latter being controllable by means of the operating device (6), and which can be moved relative to the operating surface (2) and positioned in such a way that it can be removed therefrom (2), wherein the operating element comprises a top cover (8), which is embodied at least in sections from ferromagnetic material,
wherein the operating surface (2) comprises further magnets, which are disposed on and/or under the operating surface (2),
**characterised in that**
the top cover (8) is functionally associated with the evaluation system of the operating device (6), such that a change in magnetic fields caused by the movement of the operator control element (7) on the operating surface (2), which is effected by a movement between the cover (8) and the further magnets of the operating device disposed on and/or under the operating surface (2), is detected and, via said detection of the change in magnetic fields, the movement of the operator control element (7) can be detected and consequently the desired control of the household appliance (1) or of components thereof can be effected, wherein the top cover (8) is connected to a bottom cover (9) and a closed accommodation space (12) for functional components of the operator control element (7) is embodied therebetween.

2. Operating device according to claim 1, **characterised in that** the top cover (8) is embodied at least in sections from a ferromagnetic stainless steel.

3. Operating device according to one of the preceding claims, **characterised in that** the top cover (8) is embodied at least in sections from the material having the material number 1.4021.

4. Operating device according to one of the preceding claims, **characterised in that** the top cover (8) has a ridge (11) running circumferentially around the edge, the ridge being embodied from the ferromagnetic material.

5. Operating device according to one of the preceding claims, **characterised in that** the top cover (8) is embodied for accommodating, at least in sections, other, in particular all, components of the operator control element (7).

6. Operating device according to one of the preceding claims, **characterised in that** the top cover (8) is embodied as a single piece.

## Revendications

1. Dispositif de commande pour un appareil ménager (1), muni d'une surface de commande (2), d'un système d'évaluation et d'un élément de commande (7) lequel est apte à être maintenu par force magnétique sur la surface de commande (2) de l'appareil ménager (1) commandable au moyen du dispositif de commande (6), et lequel peut être déplacé par rapport à la surface de commande (2) et être positionné sur celle-ci de manière amovible, ledit élément de commande comprenant un élément de recouvrement supérieur (8) formé au moins en partie de matériau ferromagnétique, ladite surface de commande (2) comprenant d'autres aimants disposés sur et/ou sous la surface de commande (2),
**caractérisé en ce que**
l'élément de recouvrement supérieur (8) est associé fonctionnellement au système d'évaluation du dispositif de commande (6), de telle sorte qu'un changement de champs magnétiques provoqué par le déplacement de l'élément de commande (7) sur la surface de commande (2), suite à un déplacement entre l'élément de recouvrement (8) et les autres aimants disposés sur et/ou sous la surface de commande (2) du dispositif de commande, est détecté et cette détection du changement des champs magnétiques permet de détecter le déplacement de l'élément de commande (7), permettant ainsi d'effectuer la commande voulue de l'appareil ménager (1) ou de composants de celui-ci, l'élément de recouvrement supérieur (8) étant relié à un élément de recouvrement inférieur (9) et entre les deux étant formé un espace de réception (12) pour composants fonctionnels de l'élément de commande (7).

2. Dispositif de commande selon la revendication 1, **caractérisé en ce que** l'élément de recouvrement supérieur (8) est formé au moins en partie d'un acier spécial ferromagnétique.

3. Dispositif de commande selon une des revendications précédentes, **caractérisé en ce que** l'élément de recouvrement supérieur (8) est formé au moins en partie du matériau n° 1.4021.

4. Dispositif de commande selon une des revendications précédentes, **caractérisé en ce que** l'élément de recouvrement supérieur (8) comprend une nervure (11) s'étendant autour du bord et qui est formée du matériau ferromagnétique.

5. Dispositif de commande selon une des revendications précédentes, **caractérisé en ce que** l'élément de recouvrement supérieur (8) est conçu pour recevoir au moins sur une partie d'autres composants, en particulier tous les composants de l'élément de commande (7).

6. Dispositif de commande selon une des revendications précédentes, **caractérisé en ce que** l'élément de recouvrement supérieur (8) est formé d'une seule pièce.
